# EUROPEAN PATENT APPLICATION

(11) **EP 1 126 045 A2**
(43) Date of publication of application: **22.08.2001**
(21) Application number: 01301368.5
(22) Date of filing: 16.02.2001
(51) Int. Cl.: C23C 14/50, C23C 14/35

(54) **Apparatus for coating substrates**

(30) Priority: 18.02.2000 GB 0003823
(71) Applicant: APPLIED VISION LTD, Whitwick, Leicestershire LE67 4JP (GB)
(72) Inventor: Walls, John Michael, Whitwick, Leicestershire LE67 4JP (GB); Spencer, Alaric Graham, Whitwick, Leicestershire LE67 4JP (GB); White, Norman Henry, Whitwick, Leicestershire LE67 4JP (GB); Wauch, Alan Robert, Whitwick, Leicestershire LE67 4JP (GB)
(74) Representative: Wood, Graham

(57) **Abstract**

The invention relates to the deposition of material onto surfaces of a substrate, typically respective concave and convex surfaces and provides a system whereby the substrates are held in a mutually sealed relationship by a carrier during the deposition of material onto respective surfaces thereby preventing or minimising the problem of lack of adhesion of the material on the surfaces

## Description

The invention which is the subject of the application is apparatus for coating substrates with a layer or multilayers of material and in particular to the coating of substrates with layers of material of atomic thickness.

The use of apparatus which includes means for depositing material onto substrates and means for reacting the deposited material to give the same the required composition is well known. Most, but not necessarily all techniques are performed in chambers in which there is provided a rotary carrier on which the substrates are held and which is rotated during the coating process between coating and reaction areas of the chamber.

The current invention is also directed towards the method of applying coatings which is referred to as "in-line" coating which means that the substrates to be coated follow a linear path and as they do so a coating is applied to a surface of the same and, as they progress the coating can be reacted, and further stages can allow the provision of a coating of the required multilayer configuration. In addition, the current invention is directed towards rotational coating which means that the substrates to be coated follow a rotational path and as they do so a coating is applied to a surface of the same.

In both techniques, conventionally once a coating has been applied to one surface, the substrate is required to be reversed to allow the application of coatings onto the reverse surface. It has been found that when the substrates are reversed the coating applied to the second surface can suffer from poor adhesion. It has been found that the coated material may delaminate after a period of time due to lack of adhesion which causes failure of the substrate. Having identified this problem, one solution offered by the applicant in their earlier patents has been to provide specially formed holders for each substrate, which serve to mask a second surface during the coating of a first surface of the substrate and hence prevent material directed towards the first surface from ingressing on and applying to the second surface. It is believed that this ingress is a cause of the lack of adhesion. This solution has been found to be effective when used with rotary carriers.

The aim of the present invention is to provide apparatus and a method of coating substrates which prevent the problem of particles directed to one surface to be applied thereto to form a coating for impinging on the other and improving the efficiency and speed of the coating process.

In a first aspect of the invention there is provided apparatus for applying a coating to concave and convex surfaces of at least one substrate, said apparatus including a vacuum chamber housing, at least one set of material deposition means, and a means for transporting the at least one substrate, and carrier for the same, the deposition means in the set being spaced apart in the chamber and facing each other to deposit material simultaneously or sequentially by magnetron sputtering material onto opposing surfaces of the at least one substrate which is supported by the carrier between the same, and the substrate and carrier are movable to a position between the deposition means in the set and activated in that the convex and concave surfaces are sealed from each other by contact.

In one embodiment the carrier and substrate are moved in a linear path. Alternatively they can be moved in a rotary path.

Typically there are two deposition means in each set facing opposing faces of the substrate.

In one embodiment of the invention the deposition means in each set are arranged to rotate on drums or the like and the at least one substrate follows a rotational path between the drums such that the deposition means in each set face opposing faces of the substrate.

In a further feature of the invention the vacuum chamber is provided with a first entry chamber into which the substrates can be inserted on a carrier or alternatively can be loaded onto a carrier in the entry chamber, following which a vacuum is created in the chamber and, when achieved, the entry chamber is exposed to the vacuum chamber thereby ensuring that the material deposition means are maintained in a vacuum.

Typically the material deposition means include targets of material to be deposited, using magnetron sputter deposition techniques, onto the surface of the substrate. In this technique each deposition means is a magnetron sputter device which includes a target of the material which is to be deposited and by using the known technique, the same is powered to allow the sputter deposition of particles of the target material from the target into the surrounding environment and on to, in accordance with the invention, only the exposed surface of the substrate.

In one embodiment a number of sets of deposition means can be provided at spaced intervals to allow the deposition of layers of differing materials onto the substrates to allow coatings of different materials to be achieved.

Typically the substrate carrier is either driven to move the substrates to and from the deposition means or the substrate carriers are mounted on a drive belt which moves the carriers. In one embodiment the carriers move in a continuous manner past the deposition means and reaction producing means from one end of the vacuum chamber to the other. In an alternative embodiment the drive means can cause the carriers to be moved to a deposition means or reaction producing means and leave the carrier in a stop position for a period of time while the deposition of material or reaction of the same occurs, and yet further the drive means can be controlled to exert a reciprocal drive on the substrate carrier to move the same between deposition means and reaction producing means reciprocally.

The substrate carrier is typically a plate with a series of ports into which the substrates fit or in which the substrates are held, to expose opposing surfaces of the substrate for the application of coatings thereto. Alternatively the substrate carrier includes one or more rods or the like which fit at either end of the substrate and form a seal therewith.

In whichever embodiment the deposition means in each pair can be controlled to operate simultaneously so that material is deposited on the opposing surfaces of the substrate at the same time and at the required material thickness, or sequentially and the relationship between the substrate and carrier thereby overcoming the need for preventative measures to stop the detrimental effect of particles of the material being deposited on one of the surfaces while coating the other. In addition, the time required to coat the substrate is reduced and there is no requirement for moving parts which may increase the cost of the coating process.

In some instances there is provided a seal material between the carrier and each of the substrates so that the carrier prevents the passage of deposited material from one side of the carrier to the other. In one embodiment the seal material is a resilient material such as neoprene.

In a further aspect of the present invention there is provided apparatus for applying a coating to first and second surfaces of at least one substrate having concave and convex surfaces to be coated, said apparatus including a vacuum chamber housing at least one material deposition means for the application of material onto a surface of the substrate using magnetron sputter deposition techniques, and a carrier for the substrate wherein the deposition means face the at least one substrate and the at least one substrate is rotatable about an axis of the same such that a single deposition means can deposit material onto both the first and second surfaces of the substrate.

In one embodiment, the deposition means deposit material to form a first layer, on a first surface and then the substrate is rotated and the first layer is applied to the second surface, thus forming the first layer one both surfaces prior to the substrate being exposed to a second deposition means and so on

Typically, the substrate is rotated to form the layers of material deposition on each surface. This embodiment has the advantage that the material backscattered onto the reverse surface during material deposition on the first surface is diluted and reduced.

Typically the substrate is rotated part way through the deposition of a layer of material onto a surface of the substrate. The thickness of the material layer deposited and the time of material deposition prior to rotation of the substrate can be set accordingly.

Typically the substrate is rotated through 180 degrees to expose the reverse surface following material deposition on the first or second surface and vice versa.

In one embodiment both the substrate and carrier are rotated to expose the surfaces of the substrate for material deposition.

Preferably the substrate and/or carrier are rotated by mechanical means and can include a geared mechanism or the like.

In one embodiment the rotation of the substrate is continuous. In a further embodiment the substrate is left in a stop position for a period of time while the deposition of material or reaction of the same occurs

Specific embodiments of the invention will now be described with reference to the accompanying drawings wherein
Figure 1 illustrates in schematic fashion one embodiment of coating apparatus according to the invention;
Figure 2 illustrates in schematic fashion a carrier with a substrate in accordance with the invention;
Figures 3A and B illustrate an alternative embodiment of the invention;
Figure 4 illustrates in schematic fashion one embodiment of substrate coating according to the invention;

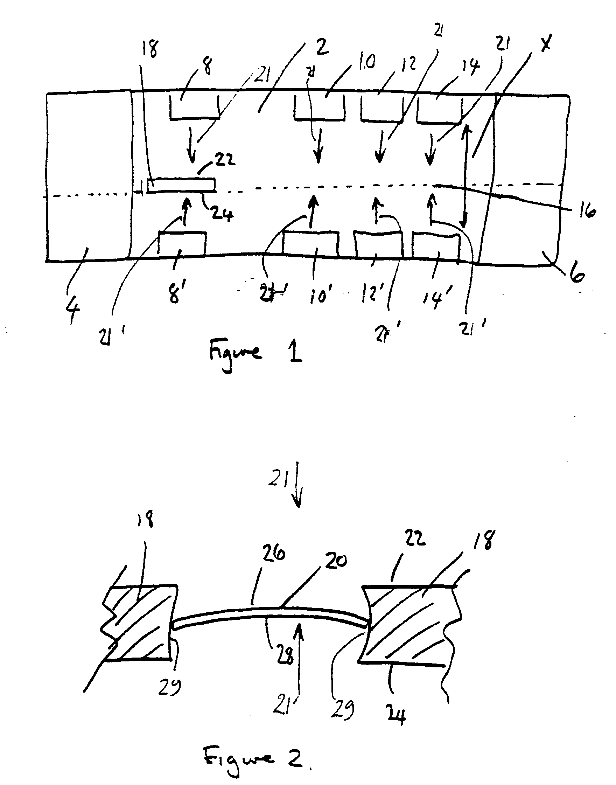

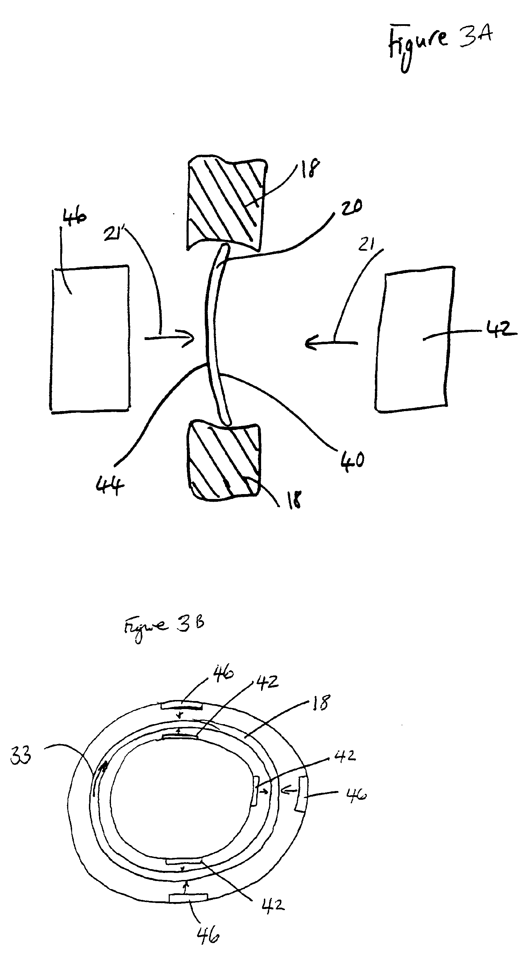

Referring now to Figure 1 there is shown a diagram of a coating apparatus in accordance with one embodiment of the invention. The apparatus comprise a vacuum chamber 2 which is connected at one end with an entry chamber 4 and at the other end with an exit chamber 6. Within the vacuum chamber there are provided a series of sets of material deposition means 8-14 and reaction producing means (not shown). Also provided is a drive belt 16 which transports a carrier 18 through the vacuum chamber and, on said carrier there are provided a number of substrates 20 which are to be coated and which in this example are uncut optical lens as shown in Figure 2.

It is apparent from the Figure 1 how each of the sets of material deposition means comprises a pair of deposition means, 8,8'; 10,10'; 12,12'; 14,14' which can be of any appropriate form such as a magnetron with a material target. Each pair of deposition means is arranged in the chamber to be spaced apart a distance X as shown and the carrier and drive means pass between the deposition means as shown. The direction of deposition of material is shown by the arrows 21,21' so that it is apparent how the deposited material moves towards opposing faces 22,24 of the carrier.

Figure 2 illustrates how the substrates may be held, in one embodiment of the carrier and may be repeated for each substrate in the carrier and it is apparent how convex face 26 of the substrate is exposed to face the deposited material 21 directed towards face 22 of the carrier and the concave face 28 of the substrate is exposed to face the deposited material 21' directed towards face 24 of the carrier so that the two surfaces of the substrate will be coated with material from different deposition means in each set. It is also apparent how the edge 29 of the substrate is sealed with the side walls 31 in the carrier thereby sealing the surface 26 of the substrate 20 from material deposited in direction 21' and the surface 28 from material deposited in the direction 21 and thereby preventing the lack of adhesive problem.

In order to apply coatings using this apparatus, one method is to open the entry chamber 4 and load onto a carrier in said chamber, which is closed to the vacuum chamber, a series of substrates. When the carrier is loaded each of the substrates has a face 26 and a face 28 exposed for the deposition of material thereon. When loaded, the entry chamber is closed to the external environment and exposed to the vacuum chamber 2 thereby ensuring that vacuum is maintained in the vacuum chamber. The carrier is then driven into the vacuum chamber where it arrives at and passes through the first set of deposition means 8, which are activated to cause a layer of material, such as Silicon, to be applied to the surfaces 26,28 of the substrates. In practise, this acts as an adhesion layer for the remaining material to be applied thereto. In this case no reaction of the materials is required and the carrier passes to the remaining sets of deposition means 10-14 which are operated to cause the deposition of material onto the respective faces 26,28 of the substrates on the carrier. Each set of deposition means is operated so that each deposition means in the set operates simultaneously with the other to apply the material to the respective surfaces of the substrates; however sequential operation may be used as an alternative. The material deposited from each of the deposition means in a set is typically the same although it is feasible that different materials could be deposited from deposition means in the same set so as to construct coatings with different characteristics on different surfaces and in this case the seal between the substrates and the carrier is effective to prevent the passage of material beyond the carrier and allow this to occur.

Within the vacuum chamber there are provided reaction producing means such as a plasma source which cause reaction of deposited material into the required chemical configuration such as, for example, the formation of oxides. In one embodiment reaction producing means are provided after each set of depositing means so as to allow the reaction of each deposited material prior to the deposition of the next material.

When the coating process is complete the carrier enters the exit chamber whereupon the chamber is sealed from the vacuum chamber, opened to the external environment and the coated substrates can be removed.

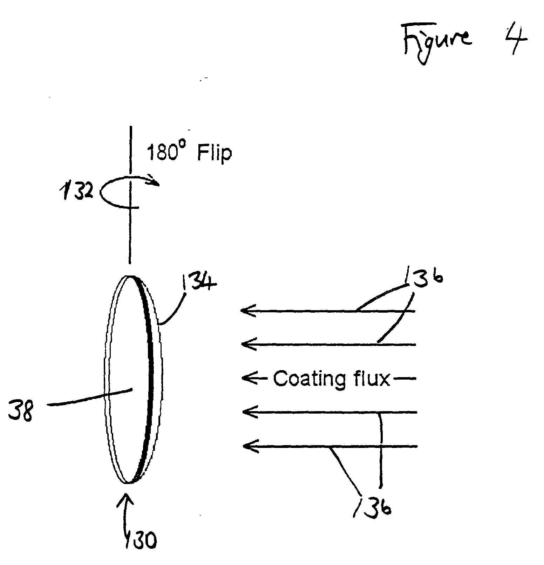

In addition to the "in-line" coating apparatus and method described above, the deposition means in each set can be arranged to rotate on drums or the like and the at least one substrate follows a rotational path between the drums such that the deposition means in each set face opposing faces of the substrate as illustrated in Figures 3A and B with Figure 3A illustrating a schematic side view. In this arrangement the substrates 20 are held vertically in the carrier 18. One face 40 of the substrate is exposed to face a deposition means 42 located on an inner holder and the opposing face 44 of the substrate is exposed to face the deposition means 46 on an outer rotating drum. The direction of deposition is shown by arrows 21, 21' and the same operating features apply as with the description of Figures 1 and 2 with the carrier 18 rotating as indicated by arrow 33.

Referring to Figure 4, there is illustrated an alternative embodiment of a means of coating a substrate using deposition means but the deposition means are arranged to deposit material onto one surface of the substrate rather than both surfaces of the substrate. The substrate 130 is held in a carrier (not shown) and the substrate and/or carrier are rotatable through 180 degrees, as shown by arrow 132. This enables a first surface 134 of the substrate 30 to be exposed to a coating flux, the direction of flux from the deposition means shown by arrows 136, prior to rotation of the substrate 130 so that a second surface 138 is exposed to the coating flux, thereby forming layers of the material on the first and second surfaces.

The substrate can be rotated for the formation of each of a plurality of layers of material on the first and second surfaces to enable a plurality of layers of material to be deposited.

The substrate can be rotated and/or the carrier can be rotated to allow exposure of the first and second surfaces for material deposition. The rotation is typically provided via mechanical means and could include a geared mechanism or the like.

The substrate carrier and/or substrate can be moved continuously or the same can be left in a stop position for a period of time while the deposition means or reaction of the same occurs.

By providing the coating of the substrates in the above embodiments described, so the simultaneous or sequential operation of the apparatus to apply layers of material to different surfaces of the same substrate in the same coating operation overcomes the need to have to mask one of the surfaces as in conventional coating arrangements to prevent the ingress of deposited material. The embodiments described dilute the effect of back-scattered material ingressing onto the opposing surface of the substrate, which in turn reduces delamination of the substrate, thus reducing a problem associated with conventional methods of substrate coating.

## Claims

1. Apparatus for applying a coating to concave and convex surfaces of at least one substrate, said apparatus including a vacuum chamber housing, at least one set of material deposition means and a means for transporting at least one substrate and carrier for the same, the deposition means in the set being spaced apart in the chamber and facing each other to deposit material simultaneously or sequentially by magnetron sputtering material onto opposing surfaces of the at least one substrate which is supported by the carrier between the same, and the substrate and carrier are movable to a position between the deposition means in the set and characterised in that the convex and concave surfaces are sealed from each other by contact of the carrier with the substrate in order to avoid cross contamination of deposited material between respective concave and convex surfaces and thereby optimise adhesion of the deposited material on the respective surfaces.

2. Apparatus according to claim 1 characterised in that the carrier and substrate are transported in a substantially linear path through the vacuum chamber and between the material deposition means in each set.

3. Apparatus according to Claim 1 characterised in that the carrier and substrate are transported in a substantially rotary path through the vacuum chamber and between the lateral deposition means in each set.

4. Apparatus according to claim 1 characterised in that each material deposition means comprises two deposition means in each set, one facing the convex face and the other facing the concave face of the substrate or substrates positioned there between.

5. Apparatus according to claim 1 characterised in that the vacuum chamber is provided with a first entry chamber into which the substrate can be inserted, following which a vacuum is created in the said entry chamber and, when achieved, the entry chamber is exposed to the vacuum chamber thereby ensuring that the material deposition means are maintained in a vacuum.

6. Apparatus according to claim 1 characterised in that the material deposition means are magnetron sputtering devices which include a target of the material to be deposited as particles onto the facing surface of the substrate.

7. Apparatus according to claim 1 characterised in that the apparatus includes a number of sets of deposition means at spaced intervals to allow the deposition of layers of different materials onto the substrate surfaces.

8. Apparatus according to claim 1 wherein the substrate carrier is driven to move the substrate within the vacuum chamber.

9. Apparatus according to claim 1 characterised in that the substrate moves in a uni-directional manner in the vacuum chamber.

10. Apparatus according to claim 1 wherein the substrate moves in a reciprocal manner in the vacuum chamber until the material deposition is completed.

11. Apparatus according to claim 1 wherein the substrate is moved in a continuous manner.

12. Apparatus according to claim 1 wherein the substrate is moved in a stepped manner in the vacuum chamber typically coming to a rest while deposition of material onto the surfaces of the substrate takes place.

13. Apparatus according to claim 1 wherein the substrate carrier includes a series of ports onto which substrates fit or in which substrates are held to expose the convex and concave surfaces of the substrate for the application of material coating thereon, from respective deposition means.

14. Apparatus according to claim 13 characterised in that the carrier contacts the edge and/or periphery of the substrates and by doing so seals the concave or convex surfaces.

15. Apparatus according to claim 14 characterised in that the carrier includes resilient material at the location of contact with the substrate to provide a sealing engagement with the substrate.

16. Apparatus according to claim 1 wherein each of the deposition means in the material deposition set are controlled to operate simultaneously such that material is deposited on opposing surfaces of the substrate at the same time.

17. Apparatus according to claim 1 characterised in that the set of depositing means includes a first deposition means to deposit a first material on one of the concave or convex surfaces and a second deposition means to deposit a second material on the other of the concave or convex surfaces.

18. Apparatus for applying a coating to first and second surfaces of at least one substrate having concave and convex surfaces to be coated, said apparatus including a vacuum chamber housing at least one material deposition means for the application of material onto a surface of the substrate using magnetron sputter deposition techniques, and a carrier for the substrate wherein the deposition means face the at least one substrate and the at least one substrate is rotatable about an axis of the same such that a single deposition means can deposit material onto both the first and second surfaces of the substrate.

19. Apparatus according to claim 14 characterised in that the rotation of the substrate takes place in a stepped manner, with the substrate coming to a rest for a predetermined period of time while material is deposited on the surface of the same which faces the material depositions.
